# EUROPEAN PATENT APPLICATION

(11) **EP 1 928 018 A2**
(43) Date of publication of application: **04.06.2008**
(21) Application number: 07022989.3
(22) Date of filing: 27.11.2007
(51) Int. Cl.: H01L 21/68, H01L 21/00

(54) **Method for attaching and peeling pressure-sensitive adhesive sheet, and attaching apparatus of pressure-sensitive adhesive sheet and peeling apparatus of pressure-sensitive adhesive sheet**

(30) Priority: 29.11.2006 JP 2006322212
(71) Applicant: NITTO DENKO CORPORATION, Osaka (JP)
(72) Inventor: Kiuchi, Kazuyuki, Ibaraki-shi Osaka (JP); Nishio, Akinori, Ibaraki-shi Osaka (JP); Shoji, Akira, Ibaraki-shi Osaka (JP)
(74) Representative: Grünecker, Kinkeldey, Stockmair & Schwanhäusser Anwaltssozietät

(57) **Abstract**

The present invention relates to a method for attaching and peeling a pressure-sensitive adhesive sheet including: attaching on a semiconductor wafer (W) a pressure-sensitive adhesive sheet having a heat shrinkable material (1) having a heat shrinkability in at least a uniaxial direction, a restriction layer (2) having a property of opposing a shrinkage deformation of the heat shrinkable material, and an energy-beam-curable pressure-sensitive adhesive layer (3) laminated in this order; subjecting the semiconductor wafer on which the pressure-sensitive adhesive sheet is attached to a predetermined treatment, followed by irradiating the semiconductor wafer with an energy beam to thereby cure the pressure-sensitive adhesive layer; and heating the pressure-sensitive adhesive sheet after the curing of the pressure-sensitive adhesive layer to thereby peeling off the pressure-sensitive adhesive sheet from the semiconductor wafer, in which, in the attaching process, the pressure-sensitive adhesive sheet is attached on the semiconductor wafer in such a way that a notch portion (N) of the semiconductor wafer is positioned at the end in the direction of the heat shrinkage (H) of the heat shrinkable material. By heating the semiconductor wafer, the pressure-sensitive adhesive sheet rises from a site of the notch portion and is then peeled while spontaneously rolling up in one direction to form a tubular shape, whereby the stress during peeling can be decreased.

## Description

### FIELD OF THE INVENTION

The present invention relates to a method for attaching and peeling a pressure-sensitive adhesive sheet onto or from a semiconductor wafer, and an attaching apparatus of a pressure-sensitive adhesive sheet and a peeling apparatus of a pressure-sensitive adhesive sheet. More particularly, it relates to a technology of attaching and peeling a pressure-sensitive adhesive sheet having heat shrinkability.

### BACKGROUND OF THE INVENTION

In recent years, a semiconductor wafer has been increased in size to a diameter of about 300 mm. On the contrary, it has been gradually decreased in thickness to 100 µm or smaller. A large and thin semiconductor wafer is very likely to be broken. Therefore, prior to grinding processing of the rear side of the wafer, a pressure-sensitive adhesive sheet for surface protection and reinforcement is attached on the wafer surface to hold the wafer, and after performing rear side grinding, the pressure-sensitive adhesive sheet is peeled off and collected from the wafer.

The pressure-sensitive adhesive sheet attached on the wafer surface generally includes an energy beam (e.g., ultraviolet ray) curable pressure-sensitive adhesive layer formed therein. The pressure-sensitive adhesive sheet is attached onto a wafer, and temporarily fixed thereon. The resulting wafer is subsequently subjected to a grinding processing, and it is then irradiated with an energy beam to cure the pressure-sensitive adhesive layer. Thus, the pressure-sensitive adhesive sheet which has been reduced in adhesion is peeled off from the wafer. However, the pressure-sensitive adhesive sheet which has been reduced in adhesion through energy beam irradiation still adheres to the wafer surface under air pressure. This necessitates the following operation in order to peel the pressure-sensitive adhesive sheet from the wafer. A release sheet is further attached on the pressure-sensitive adhesive sheet. Then, the pressure-sensitive adhesive sheet is turned up from the wafer integrally with the release sheet. During such a peeling operation, unfavorably, an excessive force acts on the wafer, so that the end of the wafer is broken, or the wafer is cracked.

Under such circumstances, there have been proposed techniques each using a pressure-sensitive adhesive sheet including an energy-beam-curable pressure-sensitive adhesive layer and a heat shrinkable film in the layer structure thereof (e.g., JP-A-2003-261842, JP-A-2000-129227, JP-A-2001-72327 and JP-A-2001-7179). According to these techniques, a wafer is irradiated with an energy beam to cure the pressure-sensitive adhesive layer. Then, the wafer is heated to shrink the heat shrinkable film. The resultant deformation of the pressure-sensitive adhesive sheet enables the peeling of the pressure-sensitive adhesive sheet from the wafer.

However, with a conventional technique using a pressure-sensitive adhesive sheet, since the shrinkage of a heat shrinkable film occurs from a plurality of directions, there arises a problem that the pressure-sensitive adhesive sheet after heating is folded one part over another on the wafer surface, whereby the peeling unfavorably becomes difficult. Further, in general, even for the products commercially available as a uniaxially shrinkable film secondary shrinkage unfavorably occurs in different axial directions due to the residual stress upon production, or due to the stress or the heat distortion applied to the pressure-sensitive adhesive sheet during the manufacturing process, or the like. Especially when a pressure-sensitive adhesive sheet is attached onto a large semiconductor wafer, the secondary shrinkage also increases, which inhibits the shrinkage in the main shrinkage axis direction, whereby the pressure-sensitive adhesive sheet tends to be difficult to be peeled off. As a result, after peeling, a part of the pressure-sensitive adhesive sheet adheres to the wafer and remains thereon; the semiconductor wafer is broken by an nonuniform stress upon shrinkage; the cured pressure-sensitive adhesive falls off from the pressure-sensitive adhesive sheet to contaminate the wafer; or other problems occur.

### SUMMARY OF THE INVENTION

In view of such circumstances, the present invention has been accomplished. It is therefore an object of the invention to provide a method for attaching and peeling a pressure-sensitive adhesive sheet capable of readily peeling off the pressure-sensitive adhesive sheet attached onto a semiconductor wafer by heating; and an attaching apparatus of a pressure-sensitive adhesive sheet, and a peeling apparatus of a pressure-sensitive adhesive sheet.

### BRIEF DESCRIPTION OF THE DRAWINGS

FIG. 1 shows a flowchart showing the step sequence of a method for attaching and peeling a pressure-sensitive adhesive sheet in accordance with Embodiment 1 of the present invention.
FIG. 2 shows a cross sectional view of the pressure-sensitive adhesive sheet for use in Embodiment 1.
FIG. 3 shows a view showing the positional relationship between a semiconductor wafer W and a pressure-sensitive adhesive sheet to be attached on the surface thereof
FIG. 4 shows a perspective view showing a schematic configuration of an attaching apparatus of a pressure-sensitive adhesive sheet for use in an attaching process of Embodiment 1.
FIG. 5 shows an explanatory view of the operation of an attaching apparatus of a pressure-sensitive adhesive sheet in accordance with Embodiment 1.
FIG. 6 shows an explanatory view of the operation of an attaching apparatus of a pressure-sensitive adhesive sheet in accordance with Embodiment 1.
FIG. 7 shows an explanatory view of the operation of an attaching apparatus of a pressure-sensitive adhesive sheet in accordance with Embodiment 1.
FIG. 8 shows an explanatory view of the operation of an attaching apparatus of a pressure-sensitive adhesive sheet in accordance with Embodiment 1.
FIG. 9 shows an explanatory view of an energy beam irradiation process of Embodiment 1.
FIGS. 10A to 10D show views for illustrating a peeling process of Embodiment 1.
FIGS. 11A to 11D show views for illustrating an example of a configuration of a peeling process of Embodiment 2.
FIGS. 12A to 12E show views for illustrating an example of a configuration of a peeling process of Embodiment 3.
FIGS. 13A to 13D show views for illustrating an example of a configuration for adhesive-sheet collection in Embodiment 4.
FIGS. 14E to 14H show views for illustrating an example of a configuration for adhesive-sheet collection in Embodiment 4.

### Description of the Reference Numerals

- W: Semiconductor wafer
- S: Pressure-sensitive adhesive sheet
- S': Tubular body of pressure-sensitive adhesive sheet
- 1: Heat shrinkable material
- 2: Restriction layer
- 3: Pressure-sensitive adhesive layer

### DETAILED DESCRIPTION OF THE INVENTION

In order to attain such an object, the present invention provides the following (1) to (8).
(1) A method for attaching and peeling a pressure-sensitive adhesive sheet comprising:
   attaching on a semiconductor wafer a pressure-sensitive adhesive sheet comprising a heat shrinkable material having a heat shrinkability in at least a uniaxial direction, a restriction layer having a property of opposing a shrinkage deformation of the heat shrinkable material, and an energy-beam-curable pressure-sensitive adhesive layer laminated in this order;
   subjecting the semiconductor wafer on which the pressure-sensitive adhesive sheet is attached to a predetermined treatment, followed by irradiating the semiconductor wafer with an energy beam to thereby cure the pressure-sensitive adhesive layer; and
   heating the pressure-sensitive adhesive sheet after said curing of the pressure-sensitive adhesive layer to thereby peeling off the pressure-sensitive adhesive sheet from the semiconductor wafer,
   wherein in said attaching, the pressure-sensitive adhesive sheet is attached on the semiconductor wafer in such a way that a notch portion of the semiconductor wafer is positioned at the end in the direction of the heat shrinkage of the heat shrinkable material.
(2) A method for attaching and peeling a pressure-sensitive adhesive sheet comprising:
   attaching on a semiconductor wafer a pressure-sensitive adhesive sheet comprising a heat shrinkable material having a heat shrinkability in at least a uniaxial direction, a restriction layer having a property of opposing a shrinkage deformation of the heat shrinkable material, and an energy-beam-curable pressure-sensitive adhesive layer laminated in this order;
   subjecting the semiconductor wafer on which the pressure-sensitive adhesive sheet is attached to a predetermined treatment, followed by irradiating the semiconductor wafer with an energy beam to thereby cure the pressure-sensitive adhesive layer; and
   heating the pressure-sensitive adhesive sheet after said curing of the pressure-sensitive adhesive layer to thereby peeling off the pressure-sensitive adhesive sheet from the semiconductor wafer,
   wherein in said peeling, the pressure-sensitive adhesive sheet is heated to be peeled off from the semiconductor wafer after applying or while applying a mechanical force to a specific site of the peripheral edge of the pressure-sensitive adhesive sheet attached on the semiconductor wafer.
(3) A method for attaching and peeling a pressure-sensitive adhesive sheet comprising:
   attaching on a semiconductor wafer a pressure-sensitive adhesive sheet comprising a heat shrinkable material having a heat shrinkability in at least a uniaxial direction, a restriction layer having a property of opposing a shrinkage deformation of the heat shrinkable material, and an energy-beam-curable pressure-sensitive adhesive layer laminated in this order;
   subjecting the semiconductor wafer on which the pressure-sensitive adhesive sheet is attached to a predetermined treatment, followed by irradiating the semiconductor wafer with an energy beam to thereby cure the pressure-sensitive adhesive layer; and
   heating the pressure-sensitive adhesive sheet after said curing of the pressure-sensitive adhesive layer to thereby peeling off the pressure-sensitive adhesive sheet from the semiconductor wafer,
   wherein in said peeling, the pressure-sensitive adhesive sheet is heated with a temperature gradient given thereto, whereby the pressure-sensitive adhesive sheet is peeled off from the semiconductor wafer.
(4) An attaching apparatus of a pressure-sensitive adhesive sheet for carrying out said attaching in the method according to (1) above,
   the apparatus comprising an alignment unit which adjust the positional relationship between the pressure-sensitive adhesive sheet and the semiconductor wafer such that the notch portion of the semiconductor wafer is positioned at the end in the direction of the heat shrinkage of the heat shrinkable material.
(5) A peeling apparatus of a pressure-sensitive adhesive sheet for carrying out said peeling in the method according to (2) above,
   the apparatus comprising a mechanical force applying unit which applies a mechanical force to a specific site of the peripheral edge of the pressure-sensitive adhesive sheet attached on the semiconductor wafer.
(6) A peeling apparatus of a pressure-sensitive adhesive sheet for carrying out said peeling in the method according to (3) above,
   the apparatus comprising a heating unit which heats the pressure-sensitive adhesive sheet with a temperature gradient given thereto.
(7) The peeling apparatus of a pressure-sensitive adhesive sheet according to (5),
   the apparatus comprising a collection unit which collects the pressure-sensitive adhesive sheet having been peeled off from the semiconductor wafer to form a tubular shape by said heating.
(8) The peeling apparatus of a pressure-sensitive adhesive sheet according to (6),
   the apparatus comprising a collection unit which collects the pressure-sensitive adhesive sheet having been peeled off from the semiconductor wafer to form a tubular shape by said heating.

In accordance with (1) above, by providing a restriction layer having a property of opposing the shrinkage deformation of a heat shrinkable material between the heat shrinkable material and an energy-beam-curable pressure-sensitive adhesive layer, shrinkage gradient occurs in the direction vertical to the surface of the pressure-sensitive adhesive sheet upon shrinking the heat shrinkable material by heating. As a result, the outer edge portion of the pressure-sensitive adhesive sheet rises from the surface of the semiconductor wafer, and is peeled off while spontaneously rolling up in one direction to form a tube shape. This can circumvent a problem of breakage of the semiconductor wafer by a stress upon peeling, contamination of the semiconductor wafer by incomplete peeling, or the like. Thus, it is possible to peel the pressure-sensitive adhesive sheet with ease. Whereas, in the attaching process, the pressure-sensitive adhesive sheet is attached on the semiconductor wafer such that a notch portion of the semiconductor wafer is positioned at the end in the direction of the heat shrinkage of the heat shrinkable material. Therefore, the outer edge portion of the pressure-sensitive adhesive sheet starts to be turned up from the notch portion of the semiconductor wafer to which a stress tends to concentrate during the heat shrinkage. In other words, since the pressure-sensitive adhesive sheet starts to be peeled off from the notch portion of the semiconductor wafer naturally, the stress during peeling can be further decreased.

In accordance with (2) above, in the peeling process, the pressure-sensitive adhesive sheet is heated to be peeled off from the semiconductor wafer after applying or while applying a mechanical force to a specific site of the peripheral edge of the pressure-sensitive adhesive sheet attached on the semiconductor wafer. Accordingly, the outer edge portion of the pressure-sensitive adhesive sheet starts to be turned up from the specific site to which a mechanical force has been applied. In other words, since the pressure-sensitive adhesive sheet starts to be naturally peeled off from a specific site of the peripheral edge of the pressure-sensitive adhesive sheet, the stress during peeling can be further decreased.

In accordance with (3) above, in the peeling process, the pressure-sensitive adhesive sheet is heated with a temperature gradient given thereto, and then peeled off from the semiconductor wafer. Accordingly, the pressure-sensitive adhesive sheet starts to be turned up from a site at which the heat shrinkage deformation is largest and the temperature is highest. In other words, since the pressure-sensitive adhesive sheet starts to be naturally peeled off from a specific site of the peripheral edge of the pressure-sensitive adhesive sheet, the stress during peeling can be further decreased.

In accordance with (4) above, it is possible to preferably carry out the method for attaching and peeling a pressure-sensitive adhesive sheet according to (1) above.

In accordance with (5) above, it is possible to preferably carry out the method for attaching and peeling a pressure-sensitive adhesive sheet according to (2) above.

In accordance with (6) above, it is possible to preferably carry out the method for attaching and peeling a pressure-sensitive adhesive sheet according to (3) above.

In accordance with (7) and (8) above, the apparatus includes a collection unit which collects a pressure-sensitive adhesive sheet having been peeled off from the semiconductor wafer to form a tubular shape. Therefore, the peeled pressure-sensitive adhesive sheet does not obstruct the subsequent peeling process, which allows continuous smooth peeling of pressure-sensitive adhesive sheets.

According to the methods for attaching and peeling a pressure-sensitive adhesive sheet in accordance with the invention, when a heat shrinkable material is shrinked by heating, the pressure-sensitive adhesive sheet rises from a specific site of the peripheral edge of the pressure-sensitive adhesive sheet, and is peeled while spontaneously rolling up in one direction to form a tubular shape. This can circumvent a problem of breakage of the semiconductor wafer by a stress upon peeling, contamination of the semiconductor wafer by incomplete peeling, or the like. Thus, it is possible to peel off the pressure-sensitive adhesive sheet with ease. Furthermore, according to the attaching apparatus of a pressure-sensitive adhesive sheet and the peeling apparatus of a pressure-sensitive adhesive sheet in accordance with the invention, it is possible to preferably carry out the method for attaching and peeling a pressure-sensitive adhesive sheet in accordance with the invention.

### Embodiment 1

In the followings, Embodiment 1 of the invention will be described by reference to the accompanying drawings.

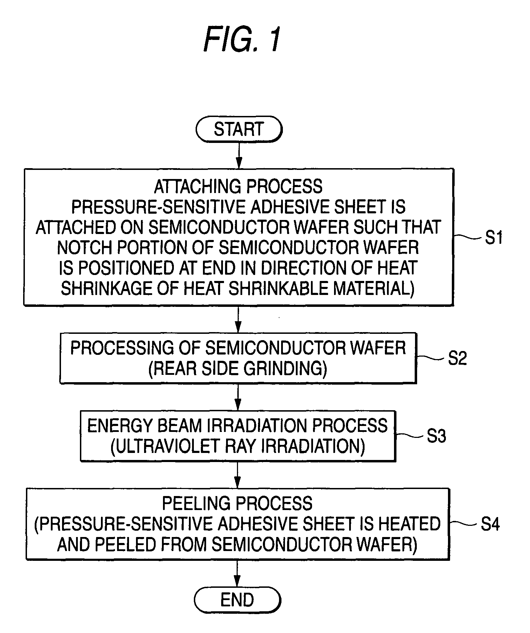

FIG. 1 is a flowchart showing the process sequence of a method for attaching and peeling a pressure-sensitive adhesive sheet in accordance with Embodiment 1.

First, in an attaching process of a step S1, a pressure-sensitive adhesive sheet formed by laminating, on a heat shrinkable material having a heat shrinkability in a uniaxial direction, a restriction layer having a property of opposing the shrinkage deformation of the heat shrinkable material and an energy-beam-curable pressure-sensitive adhesive layer in this order, is attached on a semiconductor wafer. At this step, the pressure-sensitive adhesive sheet is attached on the semiconductor wafer so that the notch portion of the semiconductor wafer is positioned at the end in the direction of the heat shrinkage of the heat shrinkable member.

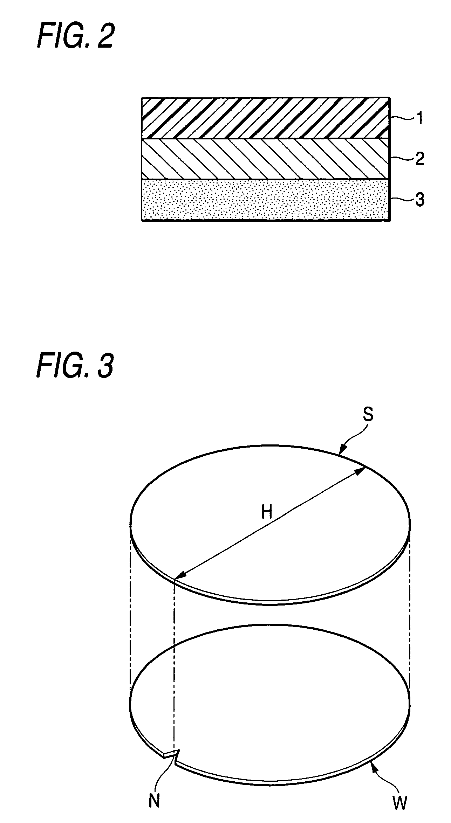

FIG. 2 is a cross sectional view of the pressure-sensitive adhesive sheet for use in this embodiment.

A heat shrinkable material 1 having a heat shrinkability in a uniaxial direction can be formed of a heat shrinkable film. It is essential only that the heat shrinkable film has a main shrinkage axis direction and it does not matter whether shrinkage occurs in one direction or in both longitudinal and transverse directions. Especially, for the purpose of minimizing the secondary shrinkage, a uniaxially-stretched film is preferable. The rate of shrinkage in the main shrinkage direction of the heat shrinkable film is, for example, 5 to 90%, and preferably 20 to 85% at a prescribed temperature in the range of 70 to 180°C (e,g., 95°C or 140°C). The rate of shrinkage in other directions than the main shrinkage direction of the heat shrinkable film is preferably 10% or less, further preferably 5% or less, and in particular preferably 3% or less. As the heat shrinkable film constituting the heat shrinkable material 1, a stretched film formed with polyester, polyethylene, polypropylene, polynorbornene, polyurethane, or the like is preferable in terms of excellent coating workability of a pressure-sensitive adhesive, or the like. The thickness of the heat shrinkable material 1 is generally 5 to 300 µm, and preferably 10 to 100 µm.

A restriction layer 2 is the layer for restricting the shrinkage of the heat shrinkable material 1. The restriction layer 2 suppresses the secondary shrinkage in different directions than the main shrinkage direction of the heat shrinkable material 1. Though the heat shrinkable material 1 is uniaxially shrinkable, the directions of shrinkage of the heat shrinkable material 1 which cannot be necessarily said to be uniform are converged into one direction. For this reason, conceivably, when a heat stimulus inducing the shrinkage of the heat shrinkable material 1 is applied to the pressure-sensitive adhesive sheet, a repulsive force in the restriction layer 2 against the shrinking force of the heat shrinkable material 1 is considered to act as a driving force. Thus, the outer edge portion (one edge, or opposing two edges) of the pressure-sensitive adhesive sheet lifts up, and spontaneously rolls up from the edge either in one direction or in the center direction (generally, in the main shrinkage axis direction of the heat shrinkable material) with the heat shrinkable material 1 side inward, resulting in the formation of a tubular roll. Furthermore, the restriction layer 2 can prevent the shear force generated by the shrinkage deformation of the heat shrinkable material 1 from being transmitted to a pressure-sensitive adhesive layer 3 or a wafer W. This can prevent breakage of the pressure-sensitive adhesive layer which has been reduced in adhesion strength upon repeeling (e.g., a cured pressure-sensitive adhesive layer), breakage of the wafer, contamination of the wafer by the broken pressure-sensitive adhesive layer, or the like.

The restriction layer 2 has elasticity and adhesiveness (including pressure-sensitive adhesiveness) with the heat shrinkable material 1, in order to exhibit a function of restricting the shrinkage of the heat shrinkable material 1. Furthermore, the restriction layer 2 preferably has a certain degree of toughness or rigidity in order to allow the smooth formation of the tubular roll. The restriction layer 2 may be constituted of a single layer, or may also be constituted of a plurality of layers in which the plurality of layers share the functions.

The restriction layer 2 is formed of, for example, an elastic layer and a rigid film layer. The elastic layer side is bonded onto the heat shrinkable material 1, and a pressure-sensitive adhesive layer 3 is formed on the rigid film layer side. Preferably, the elastic layer tends to be deformed under the temperature during shrinkage of the heat shrinkable material 1, i.e., it is in a rubber state. The elastic layer is preferably suppressed in flowability by three dimensional crosslinking or the like. For the elastic layer, for example, there can be used a resin film (including a sheet) such as a foam material (expanded film) of urethane foam or acrylic foam, the surface (at least the surface on the heat shrinkable material 1 side) of which has been subjected to an adhesion treatment, or a non-expandable resin film using rubber, thermoplastic elastomer, or the like as a material. Additionally, the elastic layer may also be formed with a resin composition having adhesiveness itself such as a crosslinkable acrylic pressure-sensitive adhesive. To the constituent components of the elastic layer, beads such as glass beads or resin beads may also be added. Addition of beads facilitates the control of the adhesion characteristics or the shear elastic modulus, which is advantageous.

The rigid layer has a function of imparting the rigidity or the toughness to the restriction layer 2. Provision of the rigid layer prevents the pressure-sensitive adhesive sheet from stopping partway or deviating in direction when a heat stimulus has been applied to the heat shrinkable material 1. Thus, the pressure-sensitive adhesive sheet smoothly rolls up spontaneously to form a balanced shape tubular roll. As the rigid film for forming the rigid layer, a polyester type resin film, a polypropylene film, a polyamide film, or the like is preferred in terms of the excellent coating workability of a pressure-sensitive adhesive, or the like. The rigid layer may be a single layer, or a multilayer including two or more layers laminated therein. The film constituting the rigid layer is non-shrinkable. The rate of shrinkage is, for example, 5% or less, preferably 3% or less, and further preferably 1% or less.

The thickness of the restriction layer 2 is generally 1 to 200 µm, and preferably 25 to 120 µm. When the thickness is too small, uneven coating may occur, or the interface breakage may occur due to excessive concentration of shrinkage stress. On the other hand, when the thickness of the restriction layer 2 is too large, the reduction of peelability due to excessive relaxation of shrinkage stress, or the reduction of the handling property and the cost efficiency is incurred. Thus, these cases are not preferred. Incidentally, when the restriction layer 2 is formed of a resin base material layer subjected to an adhesion treatment, the overall thickness thereof preferably falls within the above-mentioned numerical value range.

The energy-beam-curable pressure-sensitive adhesive layer 3 has a pressure-sensitive adhesiveness at the initial stage, and it is formed of a material which forms a three dimensional network structure through irradiation with an energy beam such as infrared ray, visible light, ultraviolet ray, X ray, or electron beam. Specifically, for example, a composition containing an energy-beam-curable compound incorporated in the base material (pressure-sensitive adhesive), and preferably a UV curable pressure-sensitive adhesive containing an ultraviolet (UV) curable compound incorporated in an acrylic pressure-sensitive adhesive are used. The thickness of the pressure-sensitive adhesive layer 3 is generally 1 to 100 µm, and preferably 10 to 60 µm. When the thickness is too small, it becomes impossible to absorb the unevenness of the wafer pattern or it becomes difficult to hold or temporarily fix the semiconductor wafer, which may incur breakage of the wafer. On the other hand, a too large thickness of the pressure-sensitive adhesive layer 3 is uneconomical, and results in inferior handling property, and hence it is not preferable.

FIG. 3 shows the positional relationship between a semiconductor wafer W and a pressure-sensitive adhesive sheet to be attached on the surface thereof In general, the semiconductor wafer W includes a notch portion N such as a V notch or an orientation flat formed therein. In this Embodiment 1, the pressure-sensitive adhesive sheet S is attached onto the semiconductor wafer W so that the notch portion N is positioned at the end in the direction of the heat shrinkage (i.e., the direction of the main shrinkage axis) H of the heat shrinkable material.

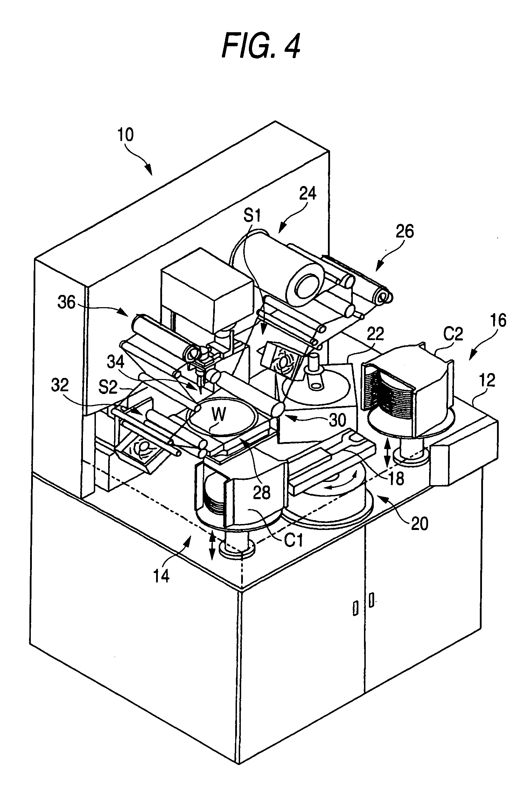

FIG. 4 is a perspective view showing a schematic configuration of an attaching apparatus of a pressure-sensitive adhesive sheet for use in the attaching process of the step S 1.

The attaching apparatus 10 of a pressure-sensitive adhesive sheet includes a wafer feed unit 14 (left-hand side) in which a cassette C including the wafer W stored therein is mounted, and a wafer collection unit 16 (right-hand side) for collecting the wafer W having a pressure-sensitive adhesive sheet S 1 attached on the surface thereof, on the left and right front of a base 12. Between the wafer feed unit 14 and the wafer collection unit 16, a wafer transport mechanism 20 including a robot arm 18 is disposed. Whereas, an alignment stage 22 is disposed at the right hand back of the base 12. Further, above that, a sheet feed unit 24 for feeding a pressure-sensitive adhesive sheet S 1 toward the wafer W is disposed. Whereas, on the right side diagonally under the sheet feed unit 24, a separator collection unit 26 for collecting only separators from the pressure-sensitive adhesive sheets S 1 each with a separator thereon fed from the sheet feed unit 24 is disposed. On the left side of the alignment stage 22, there are disposed a chuck table 28 for adsorbing and holding a wafer W, a sheet attaching mechanism 30 for attaching a pressure-sensitive adhesive sheet S 1 on the wafer W held on the chuck table 28, and a sheet peeling mechanism 32 for peeling an unnecessary sheet S2 after attaching of the pressure-sensitive adhesive sheet S1 on the wafer W. Above that, a cutter mechanism 34 for cutting the pressure-sensitive adhesive sheet S 1 attached on the wafer W along the outer shape of the wafer W. Further, on the left side above the base 12, a sheet collection unit 36 for collecting unnecessary sheets is disposed. Incidentally, the alignment stage 22 corresponds to the alignment means (alignment unit) in the attaching apparatus of a pressure-sensitive adhesive sheet in accordance with the invention.

Then, the operation of the attaching apparatus 10 will be described.

When the cassette C1 including wafers W stored in multistage therein is mounted on the cassette stage of the wafer feed unit 14, the cassette stage moves upward, and stops at the position at which the wafer W to be taken out can be taken out by means of the robot arm 18.

The wafer transport mechanism 20 turns around, so that the wafer holding portion of the robot arm 18 inserts into the clearance between the wafers W in the cassette C1. The robot arm 18 adsorbs and holds the wafer W from the rear side on the wafer holding portion, and transfers the wafer W onto the alignment stage 22.

For the wafer W mounted on the alignment stage 22, the alignment of the wafer W is carried out based on the notch portion such as an orientation flat or a notch. Specifically, when the wafer W is mounted on the chuck table 28, the wafer W is aligned so that the notch portion N of the wafer W is positioned at the end in the direction of main shrinkage axis of the pressure-sensitive adhesive sheet S 1 (in this Embodiment, in the longitudinal direction of the band-like pressure-sensitive adhesive sheet S1). After alignment, the wafer W is adsorbed and held by the robot arm 5 from the rear side, and thus transferred onto the chuck table 28.

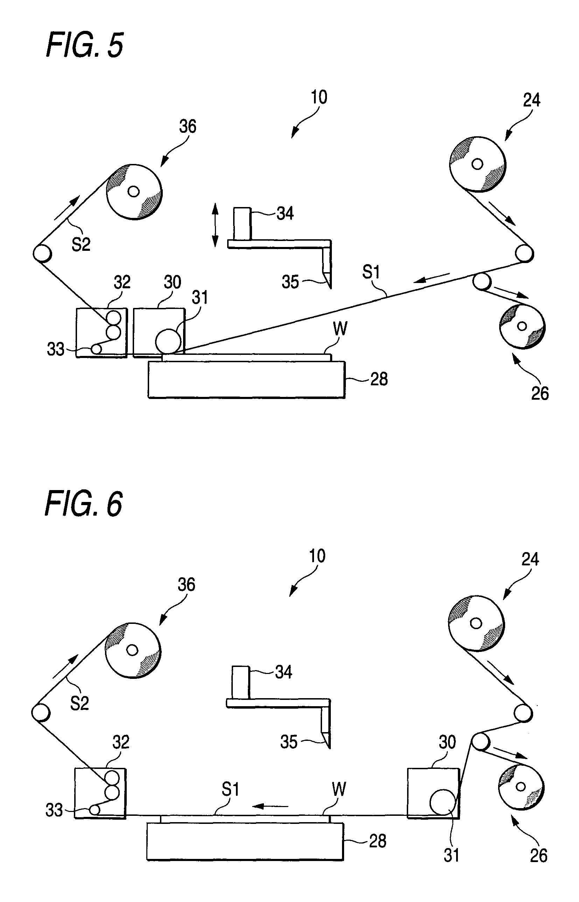

The wafer W mounted on the chuck table 28 is adsorbed and held. At this step, as shown in FIG. 5, the sheet attaching mechanism 30 and the sheet peeling mechanism 32 are positioned at the initial position on the left side, and the cutter unit 34 is positioned at the wait position on the upper side.

When the wafer W is adsorbed and held, as shown in FIG. 6, an attaching roller 31 of the sheet attaching mechanism 30 moves downward in a swinging manner. Thus, the attaching roller 31 rotates in an opposite direction from the direction of running of the sheet (in the left to right direction in FIG. 6) on the wafer W while pressing the pressure-sensitive adhesive sheet S1. As a result, it attaches the pressure-sensitive adhesive sheet S 1 uniformly over the entire surface of the wafer W. When the sheet attaching mechanism 30 reaches the completion position, the attaching roller 31 moves upward.

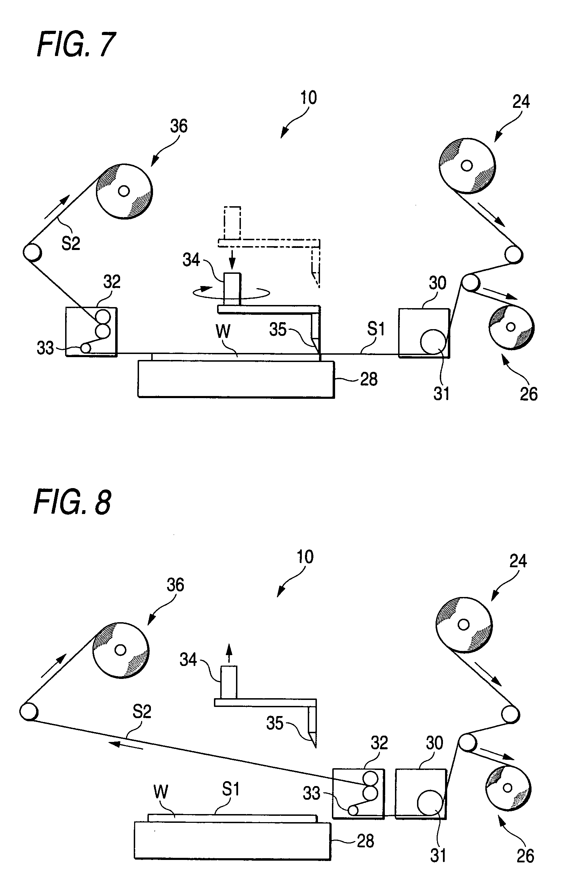

Then, as shown in FIG. 7, the cutter mechanism 34 moves downward to the cutting action position, and the cutting edge 35 pierces and penetrates through the pressure-sensitive adhesive sheet S1. The cutting edge 35 stopped at a prescribed position moves along a groove not shown provided in the chuck table 28. In other words, it continues cutting the pressure-sensitive adhesive sheet S 1 along the outer shape of the wafer W.

After cutting the pressure-sensitive adhesive sheet S1, as shown in FIG. 8, the cutter mechanism 34 moves upward, and returns to the wait position.

Then, as shown in FIG. 8, the sheet peeling mechanism 32 rolls up and peels the unnecessary sheet S2 cut on the wafer W by means of a peel roller 33 while moving in an opposite direction from the direction of running of the sheet on the wafer W.

When the sheet peeling mechanism 32 reaches the completion position of the peeling operation, the sheet peeling mechanism 32 and the sheet attaching mechanism 30 move in the direction of running of the sheet, and return to the initial position shown in FIG. 5. At this step, the unnecessary sheet S2 is rolled up to the sheet collection unit 36, and a given amount of the pressure-sensitive adhesive sheet S 1 is sent out from the sheet feed unit 24. Up to this point, a round of operations for attaching the pressure-sensitive adhesive sheet S1 on the surface of the wafer W is completed.

The process returns to FIG. 1. In the foregoing manner, the pressure-sensitive adhesive sheet S is attached on the semiconductor wafer W so that the notch portion N of the semiconductor wafer W is positioned at the end in the direction of main shrinkage of the pressure-sensitive adhesive sheet S. Then, the process goes to the subsequent step S2. At this step, the rear side of the semiconductor wafer W is ground with the pressure-sensitive adhesive sheet S attached on the surface of the semiconductor wafer W. Thus, the semiconductor wafer W is processed to a prescribed thickness.

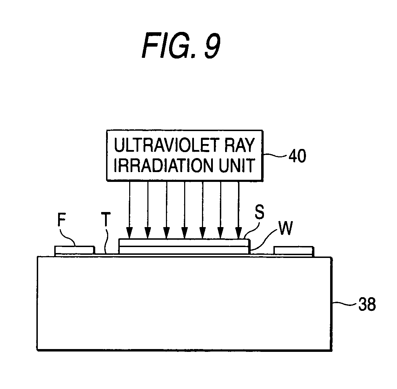

The rear side of the rear-side ground semiconductor wafer W is attached to another pressure-sensitive adhesive sheet. Thus, the wafer W is held on a ring-like frame via the pressure-sensitive adhesive sheet. Then, the process goes to the step S3 of FIG. 1. The surface of the semiconductor wafer W on which the pressure-sensitive adhesive sheet S is attached is irradiated with an energy beam (an ultraviolet ray in this Embodiment) to cure the pressure-sensitive adhesive layer 3 of the pressure-sensitive adhesive sheet S (see, FIG. 9). Incidentally, in FIG. 9, a reference sign F denotes a ring-like frame holding the wafer W via the pressure-sensitive adhesive sheet T; a reference numeral 38, a table on which the wafer W mounted on the frame F is mounted; and a reference numeral 40, an ultraviolet ray irradiation unit for irradiating the pressure-sensitive adhesive sheet S on the wafer W with an ultraviolet ray.

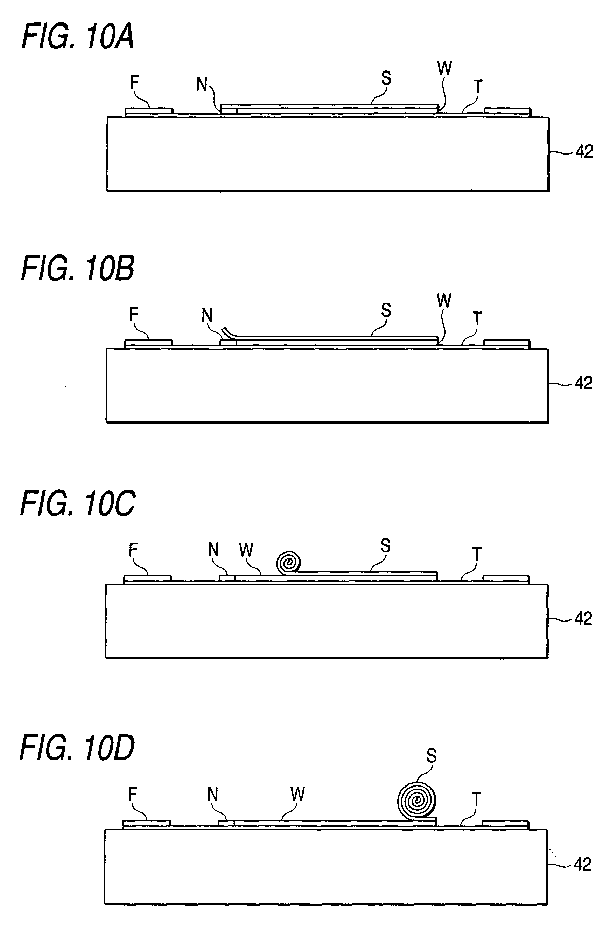

The process returns to FIG. 1. When the energy-beam-irradiation process (S3) is completed, the process goes to the peeling process of the step S4, where the pressure-sensitive adhesive sheet S is heated and peeled off from the semiconductor wafer W. Specifically, as shown in FIGS. 10A to 10D, the wafer W mounted on the frame F is mounted on a heat plate 42 (see, FIG. 10A). As a result, the pressure-sensitive adhesive sheet S attached on the wafer W is heated, so that the heat shrinkable material 1 of the pressure-sensitive adhesive sheet S shrinks in the main shrinkage axis direction. At this step, the pressure-sensitive adhesive layer 3 has already been cured, and pressure-sensitive adhesiveness thereof has been weakened. Then, in the heat shrinkable material 1, and the restriction layer 2 interposed between it and the cured pressure-sensitive adhesive layer 3, shrinkage gradient occurs in the direction vertical to the surface of the pressure-sensitive adhesive sheet S. As a result, the pressure-sensitive adhesive sheet S is bent in the main shrinkage axis direction to be turned up from the surface of the wafer W.

In the attaching process, the pressure-sensitive adhesive sheet S has been attached onto the semiconductor wafer W so that the notch portion N of the semiconductor wafer W is positioned at the end in the direction of the heat shrinkage of the heat shrinkable material. Therefore, the peripheral edge portion of the pressure-sensitive adhesive sheet S starts to be turned up from the site of the notch portion N of the semiconductor wafer W to which a stress tends to concentrate during the heat shrinkage (see, FIG. 10B).

The pressure-sensitive adhesive sheet S which has started to be turned up from the notch portion N of the semiconductor wafer W, as shown in FIGS 10C and 10D, freely runs while rolling up to form a tubular shape (curling in a tube) by itself in the direction away from the notch portion N, and it is thus peeled off from the surface of the wafer W. Thus, the pressure-sensitive adhesive sheet S starts to be peeled off from the notch portion N of the semiconductor wafer W naturally. Thus, it is peeled off from the wafer surface by its own shrinking force, and freely runs in a curled form. Therefore, the stress applied onto the wafer surface during peeling is very small, which can prevent the breakage of the edge of the wafer W or the cracking of the wafer W.

### Embodiment 2

Such a configuration that the pressure-sensitive adhesive sheet S attached on the semiconductor wafer W is turned up from a specific site is preferable in the case where the peeled pressure-sensitive adhesive sheet S is collected, or for automating the peeling process. For that purpose, in Embodiment 1, in the attaching process, the pressure-sensitive adhesive sheet S is attached on the semiconductor wafer W so that the notch portion N of the semiconductor wafer W is positioned at the end in the direction of the heat shrinkage of the heat shrinkable material. In contrast, in Embodiment 2, in the peeling process, the pressure-sensitive adhesive sheet S is heated after applying or while applying a mechanical force to a specific site of the peripheral edge of the pressure-sensitive adhesive sheet S attached on the semiconductor wafer W. As a result, the pressure-sensitive adhesive sheet S is peeled off from the site to which a mechanical force has been applied. In the case of this Embodiment, in the attaching process, it is not necessarily required that the pressure-sensitive adhesive sheet S is attached on the semiconductor wafer W so that the notch portion N of the semiconductor wafer W is positioned at the end in the direction of the heat shrinkage of the heat shrinkable material. However, it is also acceptable that the pressure-sensitive adhesive sheet S is attached in such a manner. Incidentally, the processing process of the semiconductor wafer after attaching of the pressure-sensitive adhesive sheet S (S2), and the energy irradiation process (S3) are the same as in Embodiment 1. Therefore, explanations thereon are omitted herein.

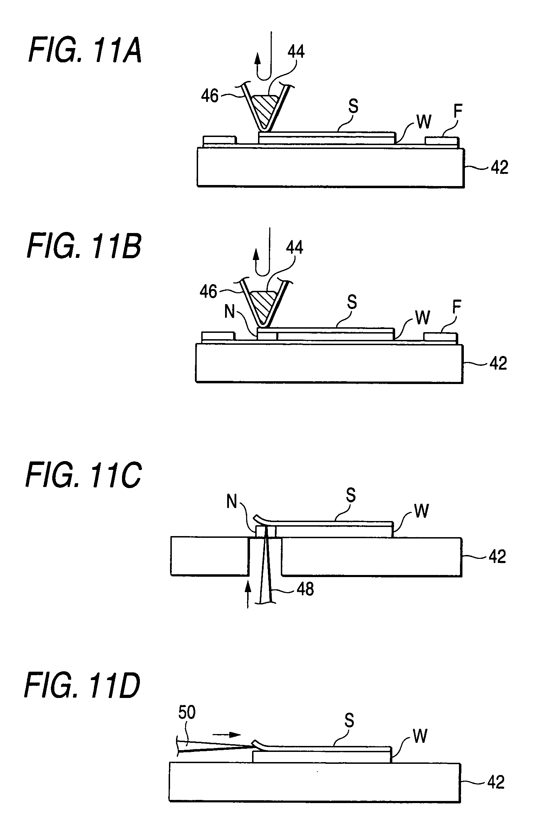

In the followings, by reference to FIGS. 11A to 11D, a description will be given to the constitution for applying a mechanical force to a specific site of the peripheral edge of the pressure-sensitive adhesive sheet S (mechanical force applying unit).

By reference to FIG. 11A, a peel tape 46 having a pressure-sensitive adhesiveness is wound over the surface of a guide member 44. The peel tape 46 is brought in light contact with the specific site of the peripheral edge of the pressure-sensitive adhesive sheet S attached on the semiconductor wafer W, and then lifted. This creates turning up (cause of peeling) of the pressure-sensitive adhesive sheet S.

By reference to FIG. 11B, as in Embodiment 1, in the attaching process, the pressure-sensitive adhesive sheet S is attached on the semiconductor wafer W so that the notch portion N of the semiconductor wafer W is positioned at the end in the direction of the heat shrinkage of the heat shrinkable material. Furthermore, in the peeling process, the peel tape 46 is brought in light contact with the pressure-sensitive adhesive sheet S at the notch portion N, and then lifted. This creates the cause of peeling for the pressure-sensitive adhesive sheet S.

By reference to FIG. 11C, in the peeling process, a thrust member 48 like a thin pin is thrust from under the notch portion N of the semiconductor wafer W. Thus, the pressure-sensitive adhesive sheet S at the notch portion N is lifted. This creates the cause of peeling for the pressure-sensitive adhesive sheet S.

By reference to FIG. 11D, in the peeling process, an insertion member 50 like a thin pin is thrust into between the semiconductor wafer W and the pressure-sensitive adhesive sheet S. Thus, the specific site of the peripheral edge of the pressure-sensitive adhesive sheet S is lifted. This creates the cause of peeling for the pressure-sensitive adhesive sheet S.

Other than these, the technique for applying a mechanical force to a specific site of the peripheral edge of the pressure-sensitive adhesive sheet S can be carried out with various modifications. For example, the following technique is also acceptable. From a thin nozzle, a clean gas such as compressed air or nitrogen gas is sprayed over the bonding surface between the semiconductor wafer W and the pressure-sensitive adhesive sheet S to thereby create the cause of peeling for the pressure-sensitive adhesive sheet S.

### Embodiment 3

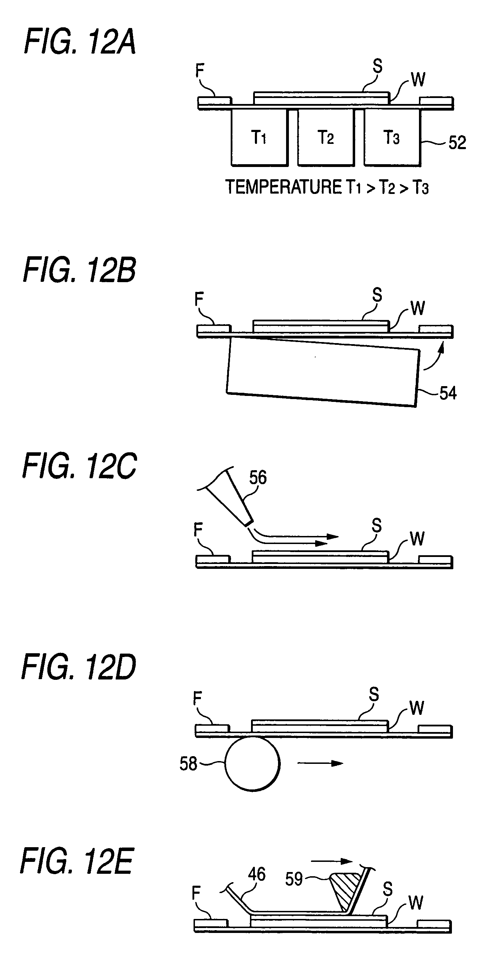

The cause of peeling of the pressure-sensitive adhesive sheet S can also be implemented by heating the pressure-sensitive adhesive sheet S with a temperature gradient given thereto, other than the techniques of Embodiments 1 and 2 described above. When the pressure-sensitive adhesive sheet S is heated with a temperature gradient given thereto, the pressure-sensitive adhesive sheet S starts to be turned up from a site at which the heat shrinkage deformation is largest and the temperature is highest. In the followings, by reference to FIGS. 12A to 12E, a description will be given to an example of the constitution for heating the pressure-sensitive adhesive sheet S with a temperature gradient given thereto (heating units). Incidentally, the processing process of the semiconductor wafer after attaching of the pressure-sensitive adhesive sheet S (S2), and the energy irradiation process (S3) are the same as in Embodiment 1. Therefore, explanations thereon are omitted herein.

By reference to FIG. 12A, by allowing a heat plate 52 on which the wafer W mounted on the frame F is mounted to have a temperature gradient, the heat shrinkage of the portion of the pressure-sensitive adhesive sheet S at a high temperature site is promoted to thereby create the cause of peeling for the pressure-sensitive adhesive sheet S at that site. In this embodiment, the temperatures T₁, T₂, and T₃ of the heat plate 52 are set to satisfy the following relationship: T₁> T₂ > T₃. Therefore, the pressure-sensitive adhesive sheet S starts to be peeled off from the site set at the highest temperature T1.

By reference to FIG. 12B, the heat plate 54 having an uniform temperature distribution is brought in contact with the rear side of the wafer W at shifted timings, whereby the temperature gradient in the pressure-sensitive adhesive sheet S is generated. This creates the cause of peeling of the pressure-sensitive adhesive sheet S at the site with which the heat plate 54 has early come in contact.

By reference to FIG. 12C, warm air is sprayed toward a specific site of the peripheral edge of the wafer W from a nozzle 56, and then the nozzle 56 is moved in one direction so that warm air is sprayed over the entire wafer W, whereby the temperature gradient in the wafer W is generated. This creates the cause of peeling of the pressure-sensitive adhesive sheet S at the site to which warm air has been early sprayed.

By reference to FIG. 12D, a roller 58 including a heater therein is brought in contact with the rear side of the wafer W and rotated in one direction, whereby the temperature gradient in the wafer W is generated. This creates the cause of peeling of the pressure-sensitive adhesive sheet S at the site with which the roller has come in contact first.

By reference to FIG. 12E, a peel bar 59 including a heater therein is horizontally moved to attach the peel tape 46 on the self-adhesive tape S, whereby the temperature gradient in the wafer W is generated. This creates the cause of peeling of the pressure-sensitive adhesive sheet S at the outer peripheral part of the wafer.

Other than these, the technique for heating the pressure-sensitive adhesive sheet S with a temperature gradient given thereto can be carried out with various modifications. For example, the following technique is also acceptable. A slit-like infrared ray is exposed from the surface side of the semiconductor wafer W and is allowed to scan in one direction along the wafer surface. This results in the occurrence of the temperature gradient in the semiconductor wafer W.

### Embodiment 4

In this Embodiment, a description will be given to an example of the constitution for collecting the pressure-sensitive adhesive sheets S peeled with the techniques of Embodiments 1 to 3 in the peeling apparatus of a pressure-sensitive adhesive sheet (collection unit). As described above, the pressure-sensitive adhesive sheet S has a property of freely running in one direction over the wafer surface while spirally rolls up to form a tubular shape by heating of the pressure-sensitive adhesive sheet S. Therefore, the peeled pressure-sensitive adhesive sheets S can be collected with ease by various techniques.

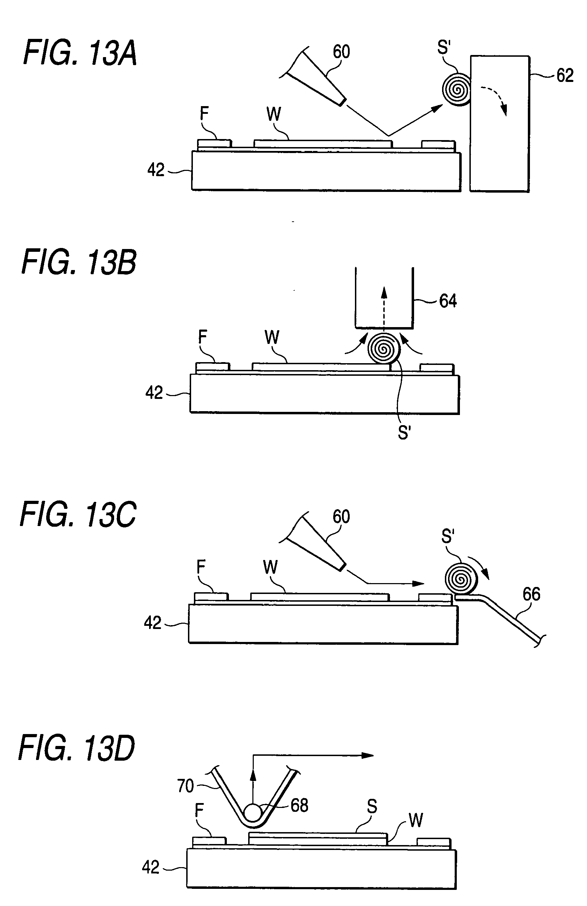

By reference to FIG. 13A, to the pressure-sensitive adhesive sheet S, which has been freely running in one direction over the wafer surface while spirally rolls up to form a tubular shape, a clean gas such as compressed air or nitrogen gas is sprayed from a nozzle 60. Thus, a tubular body S' of the rolled-up pressure-sensitive adhesive sheet is charged and collected into a collection container (duster shoot) 62.

By reference to FIG. 13B, the pressure-sensitive adhesive sheet S, which has been freely running in one direction over the wafer surface while spirally rolls up to form a tubular shape, is sucked by a suction duct 64, and collected.

By reference to FIG. 13C, to the pressure-sensitive adhesive sheet S, which has been freely running in one direction over the wafer surface while spirally rolls up to form a tubular shape, a clean gas such as compressed air or nitrogen gas is sprayed from the nozzle 60. Thus, the tubular body S' of the pressure-sensitive adhesive sheet is rotated along a guide path 66, and collected.

By reference to FIG. 13D, a peel tape 70 having pressure-sensitive adhesiveness is wound over the surface of a collection roll 68. The peel tape 70 is brought in light contact with the specific site of the peripheral edge of the pressure-sensitive adhesive sheet S attached on the semiconductor wafer W, and lifted. Subsequently, while horizontally moving the collection roll 68, peeling of the pressure-sensitive adhesive sheet S from the wafer W is promoted. Thus, the pressure-sensitive adhesive sheet S is collected together with the peel tape 70.

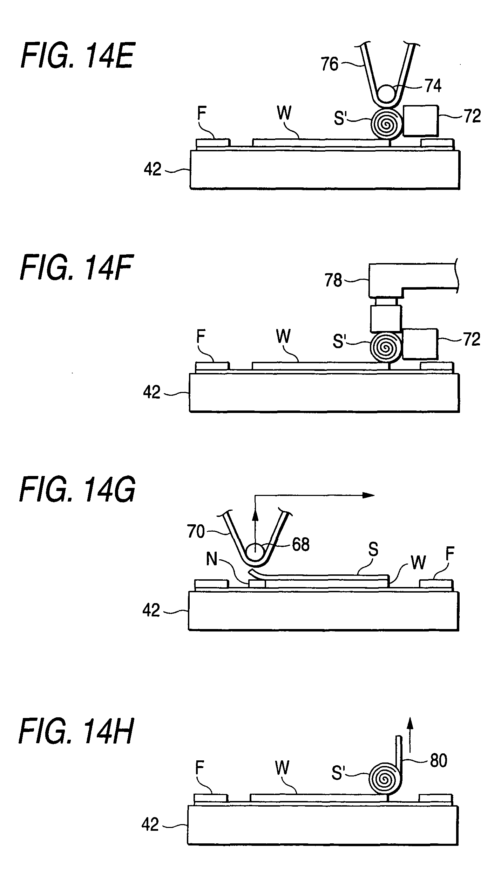

By reference to FIG. 14E, the pressure-sensitive adhesive sheet S, which has been freely running in one direction over the wafer surface while spirally rolls up to form a tubular shape, is stopped by a member 72 at one end of the wafer W. The stopped tubular body S' of the pressure-sensitive adhesive sheet is held by a collecting pressure-sensitive adhesive tape 76 wound over a guide roll 74. Thus, the tubular body S' of the pressure-sensitive adhesive sheet is collected together with the collecting pressure-sensitive adhesive tape 76.

By reference to FIG. 14F, the pressure-sensitive adhesive sheet S, which has been freely running in one direction over the wafer surface while spirally rolls up to form a tubular shape, is stopped by the member 72 at one end of the wafer W. The stopped tubular body S' of the pressure-sensitive adhesive sheet is held by the use of a robot arm 78, and collected.

By reference to FIG. 14G, with the techniques of Embodiments 1 to 3, the cause of peeling is created at a specific site of the peripheral edge of the wafer W. In addition, the site is brought in light contact with the collecting pressure-sensitive adhesive tape 76, and lifted. Subsequently, while horizontally moving the collection roll 68, peeling of the pressure-sensitive adhesive sheet S from the wafer W is promoted. Thus, the pressure-sensitive adhesive sheet S is collected together with the peel tape 70.

By reference to FIG. 14H, in the peeling process, a strip-like interleaf 80 is placed on the wafer W with the pressure-sensitive adhesive sheet S attached thereon. Thus, the heated pressure-sensitive adhesive sheet S freely runs in one direction over the wafer surface while spirally enwinding the interleaf 80 to form a tubular shape. Then, one end of the interleaf 80 extending off the tubular body S' is held, so that the pressure-sensitive adhesive sheet S is collected together with the interleaf 80.

Other than these, the constitution for collecting the pressure-sensitive adhesive sheet S can be carried out with various modifications, and is not limited to the foregoing examples.

While the present invention has been described in detail and with reference to specific embodiments thereof, it will be apparent to one skilled in the art that various changes and modifications can be made therein without departing from the scope thereof

This application is based on Japanese patent application No. 2006-322212 filed November 29, 2006, the entire contents thereof being hereby incorporated by reference.

Further, all references cited herein are incorporated in their entireties.

## Claims

1. A method for attaching and peeling a pressure-sensitive adhesive sheet comprising:
attaching on a semiconductor wafer a pressure-sensitive adhesive sheet comprising a heat shrinkable material having a heat shrinkability in at least a uniaxial direction, a restriction layer having a property of opposing a shrinkage deformation of the heat shrinkable material, and an energy-beam-curable pressure-sensitive adhesive layer laminated in this order;
subjecting the semiconductor wafer on which the pressure-sensitive adhesive sheet is attached to a predetermined treatment, followed by irradiating the semiconductor wafer with an energy beam to thereby cure the pressure-sensitive adhesive layer; and
heating the pressure-sensitive adhesive sheet after said curing of the pressure-sensitive adhesive layer to thereby peeling off the pressure-sensitive adhesive sheet from the semiconductor wafer,
wherein in said attaching, the pressure-sensitive adhesive sheet is attached on the semiconductor wafer in such a way that a notch portion of the semiconductor wafer is positioned at the end in the direction of the heat shrinkage of the heat shrinkable material.

2. A method for attaching and peeling a pressure-sensitive adhesive sheet comprising:
attaching on a semiconductor wafer a pressure-sensitive adhesive sheet comprising a heat shrinkable material having a heat shrinkability in at least a uniaxial direction, a restriction layer having a property of opposing a shrinkage deformation of the heat shrinkable material, and an energy-beam-curable pressure-sensitive adhesive layer laminated in this order;
subjecting the semiconductor wafer on which the pressure-sensitive adhesive sheet is attached to a predetermined treatment, followed by irradiating the semiconductor wafer with an energy beam to thereby cure the pressure-sensitive adhesive layer; and
heating the pressure-sensitive adhesive sheet after said curing of the pressure-sensitive adhesive layer to thereby peeling off the pressure-sensitive adhesive sheet from the semiconductor wafer,
wherein in said peeling, the pressure-sensitive adhesive sheet is heated to be peeled off from the semiconductor wafer after applying or while applying a mechanical force to a specific site of a peripheral edge of the pressure-sensitive adhesive sheet attached on the semiconductor wafer.

3. A method for attaching and peeling a pressure-sensitive adhesive sheet comprising:
attaching on a semiconductor wafer a pressure-sensitive adhesive sheet comprising a heat shrinkable material having a heat shrinkability in at least a uniaxial direction, a restriction layer having a property of opposing a shrinkage deformation of the heat shrinkable material, and an energy-beam-curable pressure-sensitive adhesive layer laminated in this order;
subjecting the semiconductor wafer on which the pressure-sensitive adhesive sheet is attached to a predetermined treatment, followed by irradiating the semiconductor wafer with an energy beam to thereby cure the pressure-sensitive adhesive layer; and
heating the pressure-sensitive adhesive sheet after said curing of the pressure-sensitive adhesive layer to thereby peeling off the pressure-sensitive adhesive sheet from the semiconductor wafer,
wherein in said peeling, the pressure-sensitive adhesive sheet is heated with a temperature gradient given thereto, whereby the pressure-sensitive adhesive sheet is peeled off from the semiconductor wafer.

4. An attaching apparatus of a pressure-sensitive adhesive sheet for carrying out said attaching in the method according to claim 1,
the apparatus comprising an alignment unit which adjust the positional relationship between the pressure-sensitive adhesive sheet and the semiconductor wafer such that the notch portion of the semiconductor wafer is positioned at the end in the direction of the heat shrinkage of the heat shrinkable material.

5. A peeling apparatus of a pressure-sensitive adhesive sheet for carrying out said peeling in the method according to claim 2,
the apparatus comprising a mechanical force applying unit which applies a mechanical force to a specific site of the peripheral edge of the pressure-sensitive adhesive sheet attached on the semiconductor wafer.

6. A peeling apparatus of a pressure-sensitive adhesive sheet for carrying out said peeling in the method according to claim 3,
the apparatus comprising a heating unit which heats the pressure-sensitive adhesive sheet with a temperature gradient given thereto.

7. The peeling apparatus of a pressure-sensitive adhesive sheet according to claim 5,
the apparatus comprising a collection unit which collects the pressure-sensitive adhesive sheet having been peeled off from the semiconductor wafer to form a tubular shape by said heating.

8. The peeling apparatus of a pressure-sensitive adhesive sheet according to claim 6,
the apparatus comprising a collection unit which collects the pressure-sensitive adhesive sheet having been peeled off from the semiconductor wafer to form a tubular shape by said heating.
